# EUROPEAN PATENT APPLICATION

(11) **EP 1 939 995 A2**
(43) Date of publication of application: **02.07.2008**
(21) Application number: 07123439.7
(22) Date of filing: 18.12.2007
(51) Int. Cl.: H02H 1/00

(54) **Methods and systems for detecting series arcs in electrical systems**

(30) Priority: 27.12.2006 US 646033
(71) Applicant: General Electric Company, Schenectady, NY 12345 (US)
(72) Inventor: Mason, JR., Henry, Farmington, CT 06032 (US); Yan, Weizhong, Farmington, NY 12065 (US); Hu, Xiao, Schenectady, NY 12309 (US); Younsi, Karim Abdelkrim, Ballston Lake, NY 12019-1022 (US); Zhou, Yingneng, Niskayuna, NY 12309 (US)
(74) Representative: Illingworth-Law, William Illingworth

(57) **Abstract**

A method of detecting a series arc in an alternating current electrical system is provided. The method is a pattern-recognition based approach and includes passing raw current signals (*y*₁) from a conductor in the electrical system through one or more filters (22) to provide a filtered signal (*y*₂); extracting one or more features (*y*₃, *y*₄*, y*₅*)* from the filtered signal (*y*₂); and classifying the features to a known state representative of the series arc.

## Description

The present disclosure is related to electrical systems. More particularly, the present disclosure is related to methods and systems for detecting series arcs in alternating current (AC) electrical systems.

The electrical systems in residential, commercial, and industrial applications usually include a panel board for receiving electrical power from a utility source. The power is routed through the panel board to one or more current interrupters such as, but not limited to circuit breakers, trip units, and others.

Each current interrupter distributes the power to a designated branch, where each branch supplies one or more loads with the power. The current interrupters are configured to interrupt the power to the particular branch if certain power conditions in that branch reach a predetermined set point.

For example, some current interrupters can interrupt power due to a ground fault, and are commonly known as ground fault current interrupters (GFCI's). The ground fault condition results when an imbalance of current flows between a line conductor and a neutral conductor, which could be caused by a leakage current or an arcing fault to ground.

Other current interrupters can interrupt power due to an arcing fault, and are commonly known as arc fault current interrupters (AFCI's). Arcing faults are commonly defined into two main categories, series arcs and parallel arcs. Series arcs can occur, for example, when current passes across a gap in a single conductor. Parallel arcs can occur, for example, when current passes between two conductors.

Unfortunately, arcing faults may not cause a conventional circuit interrupter to trip. This is particularly true when dealing with series arcing. Series arcing can potentially cause fires inside residential and commercial buildings. The potential for this to occur increases as homes become older.

Accordingly, it has been determined by the present disclosure that there is a continuing need for methods of detecting series arcs in AC electrical systems that overcome, alleviate, and/or mitigate one or more of the aforementioned and other deleterious effects of prior art systems.

According to the invention, a method of detecting a series arc in an alternating current electrical system is provided. The method is a pattern recognition based approach and includes passing raw current signals from a conductor in the electrical system through one or more filters to provide a filtered signal; extracting one or more features from the filtered signal; and classifying the features to determine if a series arc has occurred.

The invention also provides a method of detecting a series arc in an alternating current electrical system that includes inputting raw current signals from a conductor in the electrical system into a one or more filters to provide a filtered signal; extracting a plurality of features from the filtered signal; and comparing the features to the known features representative of the series arc is also provided.

The above-described and other features and advantages of the present disclosure will be appreciated and understood by those skilled in the art from the following detailed description with reference to the accompanying drawings, in which:
FIG. 1 is a block diagram of an exemplary embodiment of a method for detecting series arcing according to the present disclosure;
FIG. 2 is a schematic depiction of an exemplary embodiment of a data feature extraction step according to the present disclosure;
FIGS. 3 through 5 are graphs comparing one or more cycles of the extracted data in use in a first exemplary embodiment of the feature extraction step;
FIGS. 6 through 8 illustrates graphs comparing multiple cycles of the extracted data in use in a second exemplary embodiment of the feature extraction step; and
FIG. 9 is a schematic depiction of a system for detecting series arcing according to the present disclosure.

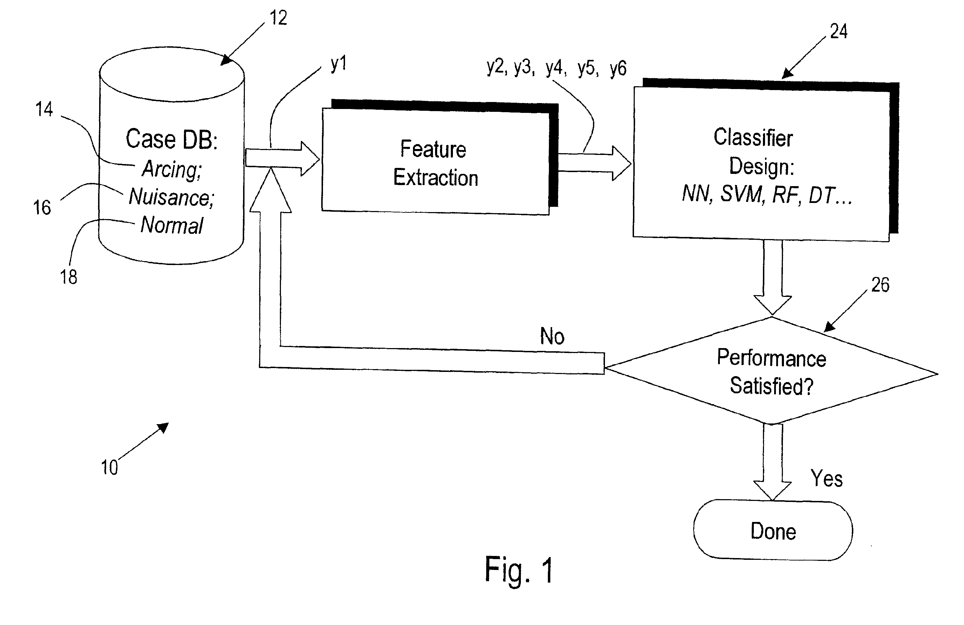

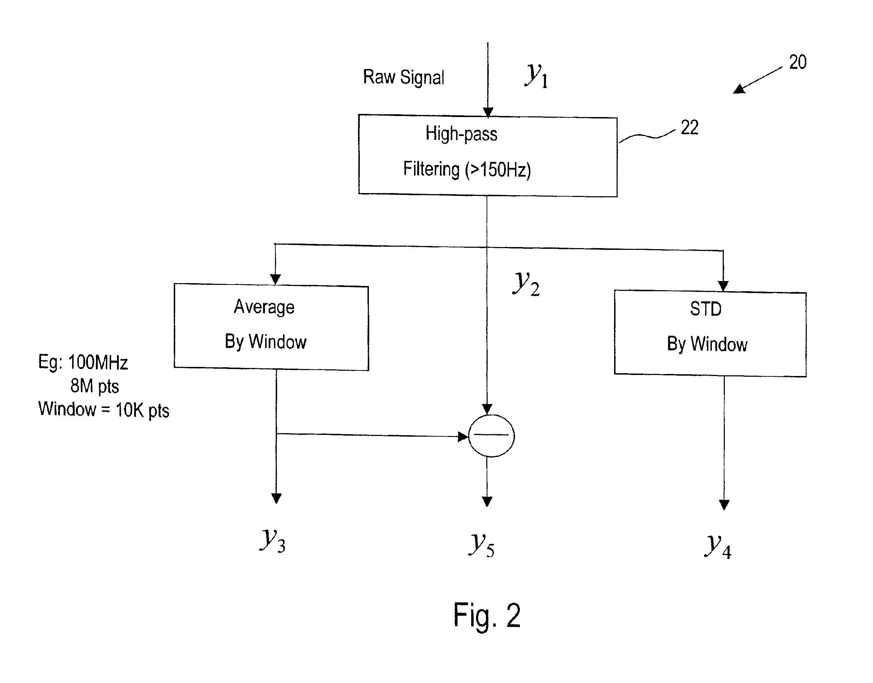

Referring to the drawings and in particular to FIGS. 1 and 2, a method for detecting series arcing according to the present disclosure is shown and is generally referred to by reference numeral 10. Method 10 utilizes a pattern recognition approach to extract a plurality of features from the sensed current across a current interrupter and to determine which feature or subset of features can be used to detect series arcing events. In some embodiments, method 10 can determine the cause (e.g., compressor arc) of the detected series arcing event.

Accordingly, method 10 provides a tool that is useful in the recognition and differentiation of the current signal patterns that are indicative of normal and nuisance conditions, from current signal pattern(s) that are indicative of series arcing conditions. Thus, method 10 uses a data-driven approach to detect series arcing in AC electrical systems.

Method 10 includes the use of a database 12. Database 12 includes a large number of raw signals (y₁) such as, but not limited to waveforms, measured from a plurality of conditions in an AC electrical system. In an exemplary embodiment, raw signals (y₁) are measured by a bimetal of a current interrupter in a known manner. Thus, raw signals (y₁) include line current on a conductor in series with the bimetal.

Database 12 includes the raw signals (y₁) from instances of arcing loads 14, both series and parallel, nuisance loads 16, and normal loads 18, where nuisance loads 16 include raw signals (*y*₁) from one or more cases representing inrush signals.

Method 10 inputs the raw signals (*y*₁) from database 12 into a feature extraction step 20. Feature extraction step 20, as shown in FIG. 2, passes or conditions the raw signals (y₁) through one or more filters 22 (only one shown) to provide filtered signal y₂. In the illustrated embodiment, filter 22 is shown as a high-pass filter. Of course, it is contemplated by the present disclosure for feature extraction step 20 to condition the raw signals (y₁) through other filters such as, but not limited to, high-pass filters, low-pass filters, band-pass filters, and any combinations thereof to generate the desired filtered signal y₂. In some embodiments, feature extraction step 20 can include one or more signal processing algorithms to, for example, filter out outlier signals and/or unusual signals.

Once filtered, feature extraction step 20 uses filtered signal y₂ to calculate one or more features of the filtered signal. In the illustrated embodiment, feature extraction step 20 is shown calculating three statistical features (*y*₃, *y*₄, *y*₅) from filtered signal *y*₂. Here, feature *y*₃ is illustrated as the mean of filtered signal *y*₂, feature *y*₄ is the standard deviation of the filtered signal, and feature *y*₅ is the difference between *y*₂ and *y*₃.

For purposes of clarity, feature extraction step 20 is illustrated determining only three statistical features from filtered signal y₂. However, it is contemplated by the present disclosure for feature extraction step 20 to calculate any known features including, but not limited to, the mean of the full cycle, the standard deviation of the full cycle, the maximum standard deviation of a window of signal (where window width can vary) in the cycle, the minimum standard deviation of a window of signal in the cycle, the ratio of the maximum and minimum standard deviations, the absolute sum of each sample in the cycle, the relation of the standard deviations (or variances) for each adjacent window in the cycle, the RMS value, the difference between adjacent points for features such as, but not limited to, the maximum difference between two adjacent samples, the minimum difference between two adjacent samples, the ratio of the maximum difference to the minimum difference, the range of the signal differences (e.g., the maximum difference minus the minimum difference), the sum of the differences between adjacent points, the difference between adjacent points in the above mentioned first difference signal, features such as, but not limited to, the maximum difference between two adjacent samples, the minimum difference between two adjacent samples, the ratio of the maximum difference to the minimum difference, the range of the difference signal (e.g., the maximum difference minus the minimum difference), the sum of the differences between adjacent points, the number of distinct peaks in the signal *y*₂, and others. As used herein, the term "window of signal" means that a full cycle of the waveform signal has been broken down into multiple windows or equal or different length.

In this manner, feature extraction step 20 measures and characterizes the signals/waveforms of the instances of arcing loads 14, nuisance loads 16, and normal loads 18 in database 12.

It has been determined by the present disclosure that, once various features have been extracted, these features can be evaluated by classifying the characterized waveform features as a series arc, a parallel arc, a normal condition or a nuisance condition. Method 10 includes a classifier design step 24, which classifies the waveform features.

Classifier design step 24 can be any classification system such as, but not limited to, a decision tree (DT), a neural network (NN), a random forest (RF), a support vector machine (SVM), any combinations thereof, and others.

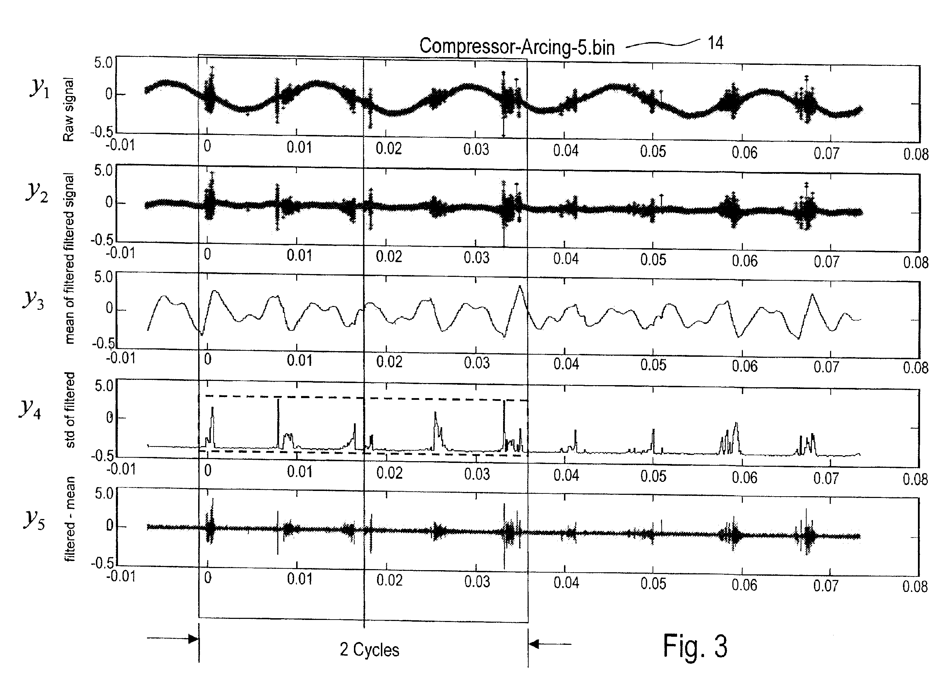

For purposes of clarity, a first exemplary embodiment of a classifier design step 24 is described herein with reference to FIGS. 3 through 8 as a decision tree.

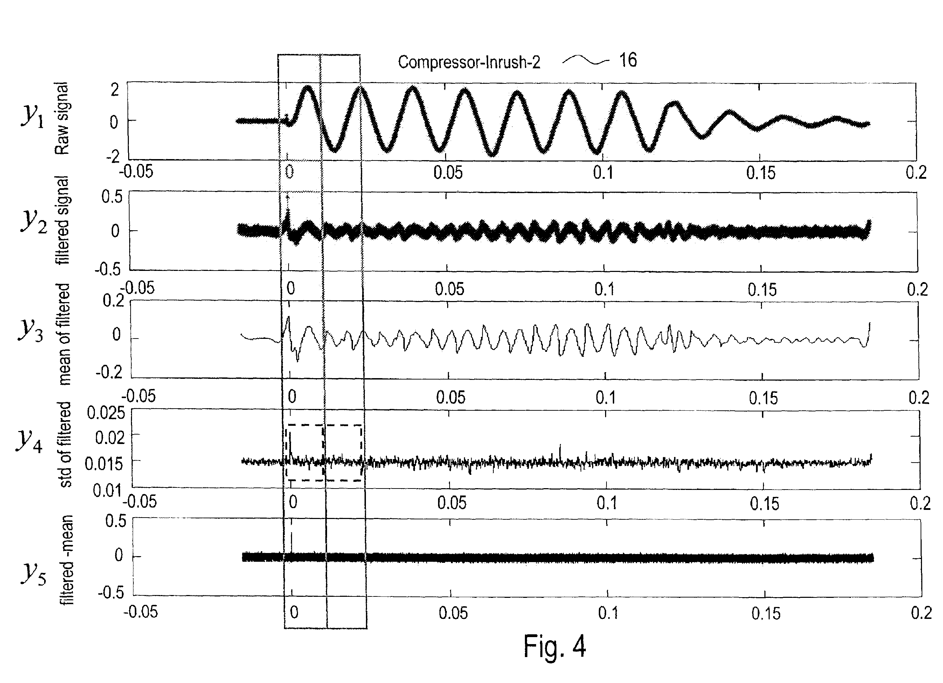

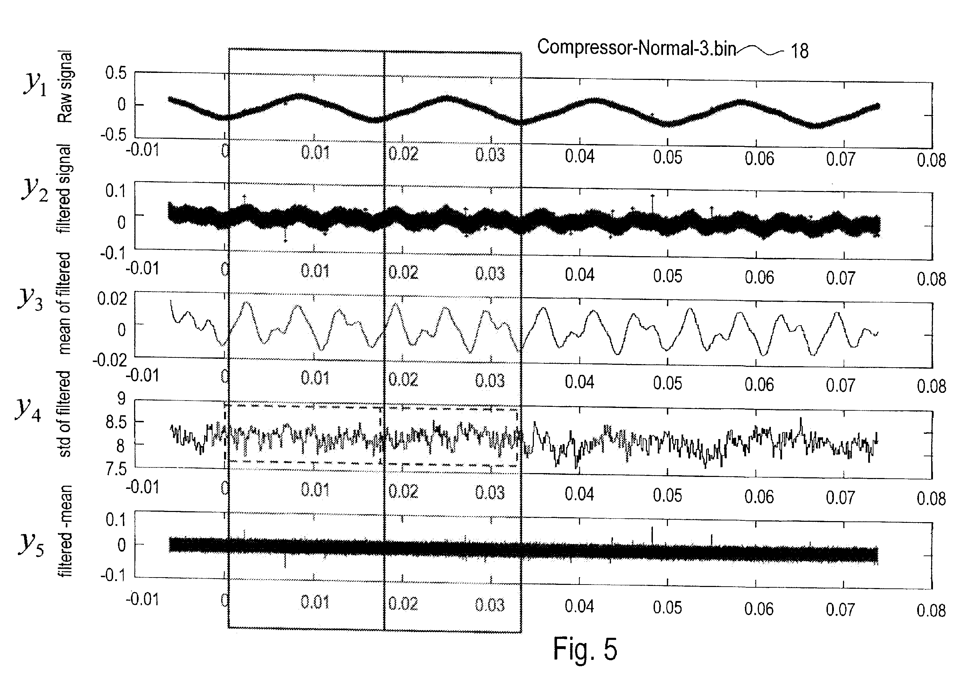

FIG. 3 illustrates graphs comparing one or more cycles of raw signals, filtered signals, and corresponding extracted features (*y*₁, y₂, y₃, *y*₄, *y*₅) representing an arcing condition 14 of a compressor. FIG. 4 illustrates graphs comparing one or more cycles of data (*y*₁, *y*₂, *y*₃*, y*₄, *y*₅) representing nuisance (i.e., inrush) condition 16 of the compressor, while FIG. 5 illustrates graphs comparing one or more cycles of data (*y*₁, *y*₂, *y*₃, *y*₄, *y*₅) representing a normal condition 18 of the compressor.

It was determined by the present disclosure that application of decision tree analysis to data (*y*₁, y₂, y₃, *y*₄, *y*₅), that certain features can be used to detect the arcing condition of the compressor. For example, it can be seen that the graphs of the filtered-mean statistical feature (*y*₅) for the arcing condition 14 in FIG. 3 provides a unique burst pattern of current signal when series arcing occurs, where this same pattern is absent in the filtered-mean statistical feature (*y*₅) for the normal and nuisance conditions 16, 18 of FIGS. 4 and 5.

In some embodiments, the decision tree can be applied to more than one cycle of data. By looking at more than one cycle, classifier design step 24 can, in some instances, determine particular features not possible when looking at only one cycle. For example, multiple cycles can be used to eliminate events that are periodic or one time to further differentiate between nuisance signals and arcing.

Once classifier design step 24 classifies one or more particular features as indicators of, for example, a series arcing condition, method 10 includes a testing step 26 shown in FIG. 1. Here, the particular identified feature(s) (*y*₁, y₂, *y*₃, *y*₄, *y*₅) can be tested against other instances of series arcing 14 in database 12 to determine whether the performance of the identified feature is acceptable, namely whether that feature is an effective indicator of the desired condition.

If the one or more particular identified features (*y*₁, *y*₂, *y*₃, *y*₄, y₅), when run on the data within database 12, properly indicate the desired condition, then method 10 is done and that feature can be used as a detector of the desired condition with desired performance. However, if the particular identified feature (*y*₁, *y*₂, y₃, *y*₄, *y*₅), when run on the raw signals within database 12, does not properly indicate the desired condition, then method 10 returns to look at a different feature of the waveform.

Accordingly, method 10 provides a data-driven approach that allows for extracting and selecting features from the waveform as being indicators of a particular condition such as, but not limited to, a series arc condition, a parallel arc condition, a normal condition, a nuisance condition, and any combinations thereof. Moreover, it is contemplated by the present disclosure for method 10 to find equal use as a detector of other conditions of the waveform such as, but not limited to, ground faults, and others.

Advantageously, method 10 is configured to generate a number of different features, which are then used to differentiate the pattern of a series arcing signal from the pattern of normal conditioned signal and the signals with various nuisance loads.

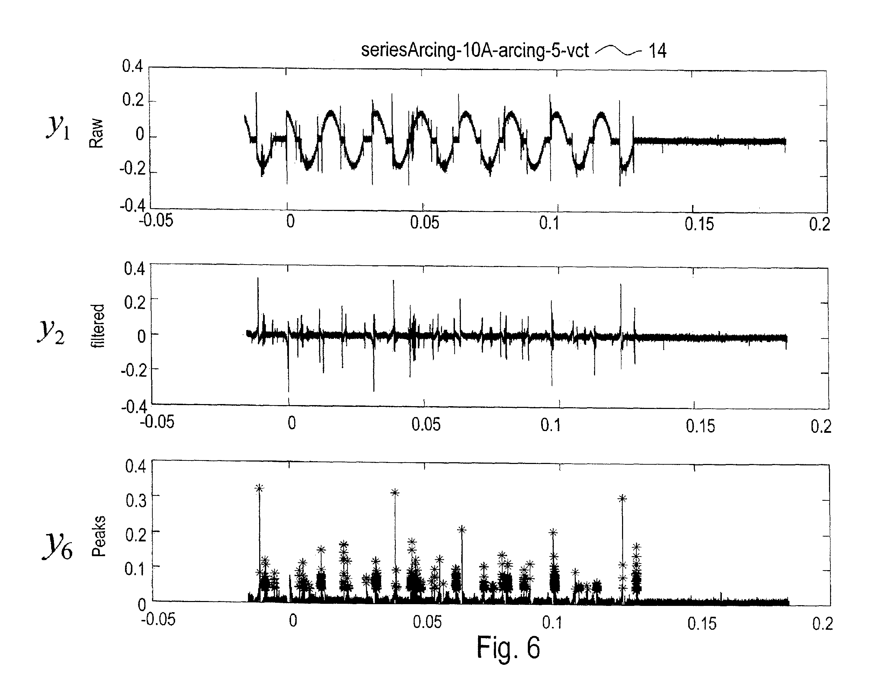

Referring now to FIGS. 6 through 8, a second exemplary embodiment of a classifier design step 24 is shown. In this embodiment, classifier design step 24 focuses on the signal peak signatures (y₆) of the features of the waveforms from feature extraction step 20. As such, feature extraction step 20 for use with the second embodiment of classifier design step 24 can calculate signal peak signatures (y₆) by calculating any known peak domain feature including, but not limited to, minimum of peak amplitude, maximum of peak amplitude, difference of minimum and maximum amplitudes, mean of peak amplitude, standard deviation of amplitude, kurtosis of peak amplitude, skewness of peak amplitude, root mean square (RMS) of peak amplitude, crest factor of peak amplitude, number of peaks per unit time, and others. In addition, feature extraction step 20 for use with the second embodiment of the classifier design step 24 can calculate signal peak signatures (y₆) by calculating any known peak shape statistics such as, but not limited to, the second order moment of shape, the third order moment of shape, the fourth order moment of shape, the time distance from maximum peak to centroids of peaks, and others.

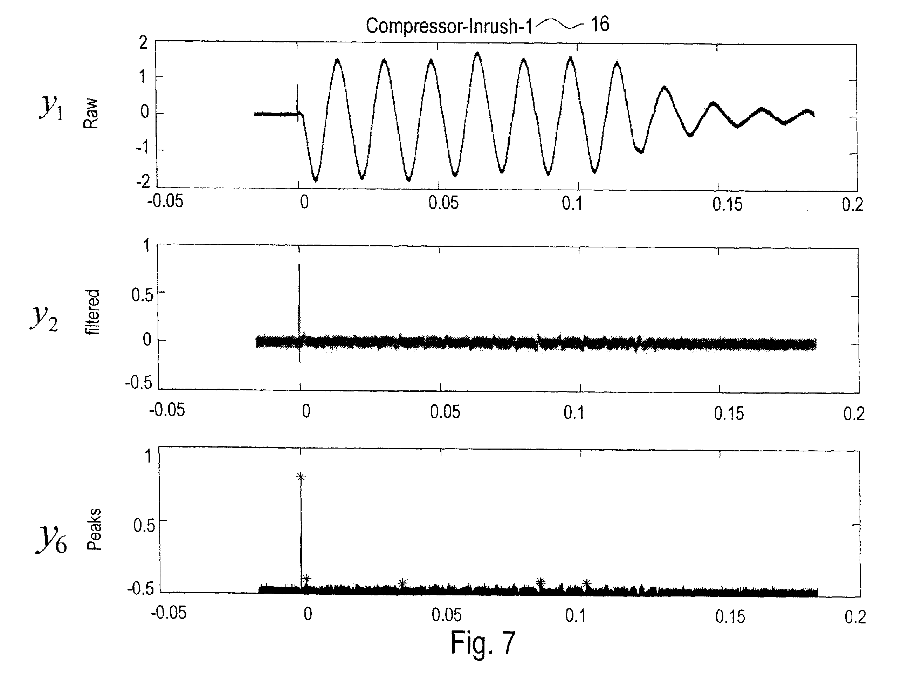

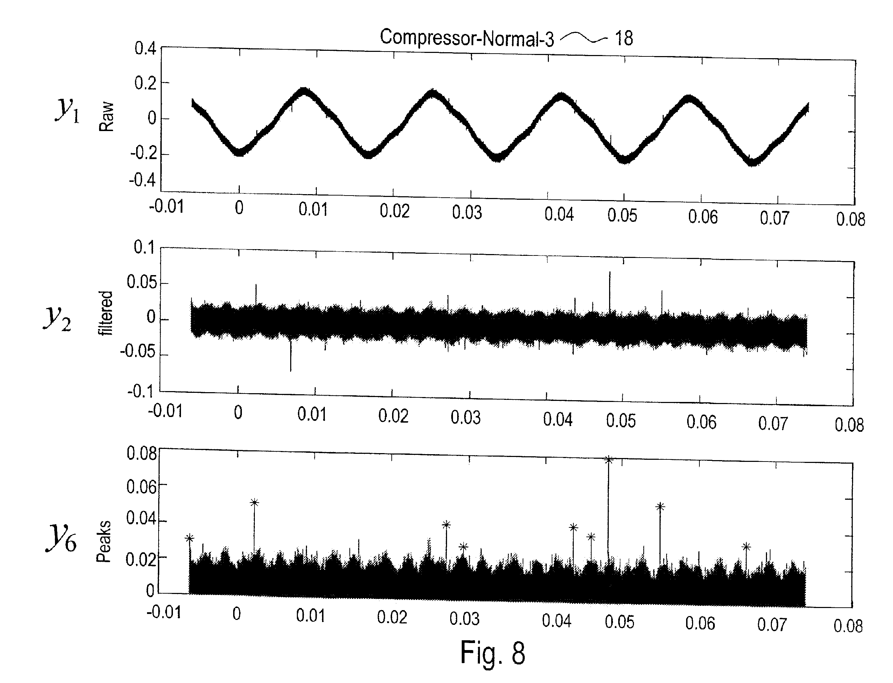

FIG. 6 illustrates graphs comparing one or more cycles of data (*y*₁, *y*₂, *y*₆) representing a series arcing condition 14 of the compressor from database 12. FIG. 7 illustrates graphs comparing one or more cycles of data (*y*₁, y₂, y₆) representing nuisance (i.e., inrush) condition 16 of the compressor, while FIG. 8 illustrates graphs comparing one or more cycles of data (y₁, y₂, y₆) representing a normal condition 18 of the compressor.

As can be seen in FIG. 6, the graph of the peak features y₆ illustrates a unique burst pattern of current signal when series arcing occurs, where this same pattern is absent in the same peak feature (y₆) for the normal and nuisance conditions 16, 18 of FIGS. 7 and 8. Thus, classifier design step 24 can identify this peak signature feature to detect series arcing.

In all embodiments, method 10 can be used to extract any number of discriminant features that characterize the current signals corresponding to different conditions (i.e., series arcing, parallel arcing, nuisance loads, normal loads, etc.) to accurately and reliably differentiate series arcing from normal operation of the AC electrical system.

Once the features that detect series arcing are determined, these features can be used in a system such as, but not limited to, an arc fault circuit interrupter (AFCI), to generate a trip signal so that the circuit is timely disconnected before the arc fault causes any further damages to other appliances connected in the system. For example, an AFCI can be provided that continuously compares current signals in the AC electrical system to features predetermined by method 10 to be indicative of a series arc fault and to use the outcome of this comparison to cause the AFCI to trip and protect the circuit and other appliances connected in the system. Thus, such an enabled AFCI device can be configured to trip only when series arcing occurs.

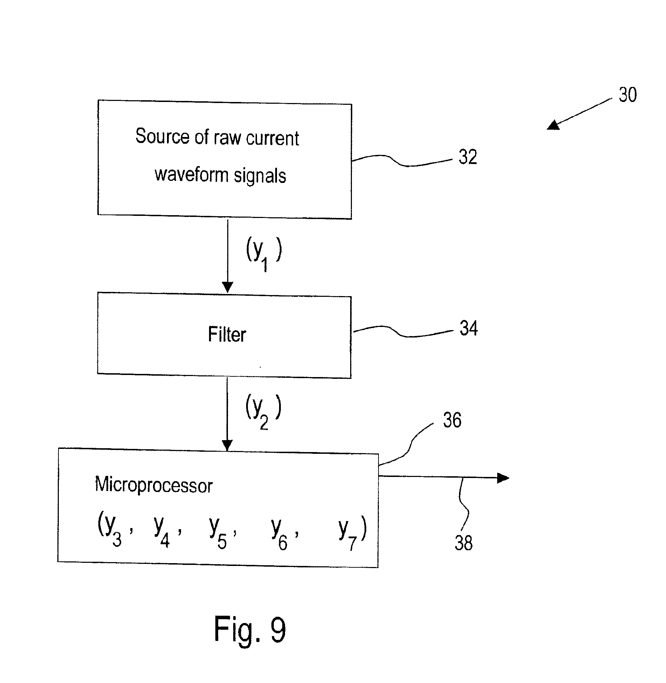

Referring now to FIG. 9, an exemplary embodiment of a system 30 for detecting series arcing faults is shown. System 30 includes a signal source 32, a filter 34, and a microprocessor 36.

Source 32 can be any desired source of raw current waveform signals (y₁). In one embodiment, source 32 can be database 12 discussed above. In another embodiment, source 32 is a bimetal of a current interrupter.

System 30 passes raw signals (*y*₁) from source 32 through filter 34. Filter 34 is configured to condition raw signals (*y*₁) and to provide filtered signals (y₂) to microprocessor 36. Filter 34 can be a filtering circuit, a filtering algorithm resident on microprocessor 36, and any combinations thereof. For example, filter 34 can be a high-pass filter, a low-pass filter, a band-pass filter, a signal processing algorithm, and any combinations thereof.

System 30 provides filtered signals (*y*₂) from filter 34 to microprocessor 36. Microprocessor 36 is configured to generate one or more features (*y*₃, *y*₄, *y*₅, *y*₆) from filtered signal (*y*₂). Further, microprocessor 36 is configured to compare the features (*y*₃, *y*₄, *y*₅, *y*₆) to one or more known features representative of particular conditions of the raw current waveform signals (*y*₁). For example, microprocessor 36 can compare the features (*y*₃, *y*₄, *y*₅, *y*₆) to one or more predetermined features resident on microprocessor, where the one or more predetermined features can be indicative of a condition such as a normal condition, a nuisance condition, a series arcing condition, a parallel arcing condition, a ground fault, and any combinations thereof.

In this manner, system 30 is configured to recognize and differentiate the raw current waveform signals (*y*₁) that are indicative of normal and nuisance conditions, from raw current waveform signals (*y*₁) that are indicative of a particular fault condition, such as series or parallel arcing conditions. Further, system 30 is configured to determine the cause of the particular fault condition (e.g., compressor series arc).

In one embodiment, system 30 is resident on an arc fault circuit interrupter (AFCI). Here, microprocessor 36 can provide a trip signal 38 to the arc fault circuit interrupter when system 30 detects one or more fault conditions.

It should also be noted that the terms "first", "second", "third", "upper", "lower", and the like may be used herein to modify various elements. These modifiers do not imply a spatial, sequential, or hierarchical order to the modified elements unless specifically stated.

## Claims

1. A method (10) for detecting a series arc in an alternating current electrical system, comprising:
passing raw current signals (*y*₁) from a conductor in the electrical system through one or more filters (22) to provide a filtered signal (y₂);
extracting one or more features (y₃, *y*₄, *y*₅) from said filtered signal (y₂); and
classifying said one or more features *(y₃, y₄, y*₅) to a known state of the series arc.

2. The method as in claim 1, wherein said one or more features comprises a feature selected from the group consisting of a mean of said filtered signal, a standard deviation of said filtered signal, a mean filtered signal, a mean of a full cycle, a standard deviation of a full cycle, a maximum standard deviation of a window of signal in a cycle, a minimum standard deviation of a window of signal in a cycle, a ratio of the maximum and minimum standard deviations, an absolute sum of each sample in a cycle, a relation of the standard deviations for each adjacent window in a cycle, a root mean square value, a maximum difference between two adjacent samples, a minimum difference between two adjacent samples, a ratio of the maximum difference to the minimum difference, a range of the difference signal, a sum of the differences between adjacent points, and any combinations thereof.

3. The method as in claim 1, wherein said one or more features comprises a peak feature (y₆) selected from the group consisting of a minimum of peak amplitude, a maximum of peak amplitude, a difference of minimum and maximum amplitudes, a mean of peak amplitude, a standard deviation of amplitude, a kurtosis of peak amplitude, a skewness of peak amplitude, a root mean square (RMS) of peak amplitude, a crest factor of peak amplitude, number of peaks per unit time, and any combinations thereof.

4. The method as in claim 1, wherein said one or more features comprises a peak feature (y₆) selected from the group consisting of a second order moment of a peak shape, a third order moment of a peak shape, a fourth order moment of a peak shape, a time distance from maximum peak to centroids of peaks, and any combinations thereof.

5. The method as in any one of claims 1 to 4, wherein said one or more filters is selected from the group consisting of a high-pass filter, a low-pass filter, a band-pass filter, a signal processing algorithm, and any combinations thereof.

6. The method as in any one of claims 1 to 5, further comprising measuring said raw signals across a bimetal in series with said conductor.

7. The method as in any one of claims 1 to 5, further comprising inputting said raw signals to said one or more filters from a database (12) of raw signals.

8. The method as in any one of claims 1 to 7, further comprising performing classifying features using one or more different classifiers, said one or more classifiers being selected from the group consisting of a decision tree, a neural network, a support vector machine, a random forest, and any combinations thereof.

9. A method (10) for detecting a series arc in an alternating current electrical system, comprising:
inputting a raw current signal (*y*₁) from a conductor in the electrical system into one or more filters (22) to provide a filtered signal (y₂);
extracting a plurality of features *(y₃, y₄, y*₅) from said filtered signal (*y*₂); and
comparing said plurality of features (*y*₃, *y₄, y*₅) to a known feature representative of the series arc.

10. The method as in claim 9, wherein said known feature comprises a shape signature of said plurality of features, a peak feature signature (y₆) of said plurality of features, and any combinations thereof.
